# EUROPÄISCHE PATENTSCHRIFT

(11) **EP 4 058 250 B1**
(45) Veröffentlichungstag und Bekanntmachung des Hinweises auf die Patenterteilung: **21.10.2026**
(21) Anmeldenummer: 20800916.7
(22) Anmeldetag: 04.11.2020
(51) Int. Cl.: B25D 17/04, B25D 11/00, B25F 5/00, B25F 5/02, H03K 17/97, G01D 5/14

(54) **VERFAHREN ZUM STEUERN UND REGELN EINER WERKZEUGMASCHINE**
METHOD FOR CONTROLLING AND REGULATING A MACHINE TOOL
PROCÉDÉ DE COMMANDE ET DE RÉGLAGE D'UNE MACHINE-OUTIL

(30) Priorität: 14.11.2019 EP 19209149
(43) Veröffentlichungstag der Anmeldung: 21.09.2022
(73) Patentinhaber: Hilti Aktiengesellschaft, 9494 Schaan (LI)
(72) Erfinder: RINGLER, Stefan, 86853 Schwabmühlhausen (DE); MAHDIZADEH, Ehsan, 86916 Kaufering (DE)
(74) Vertreter: Hilti Aktiengesellschaft Corporate Intellectual Property
(86) Internationale Anmeldenummer: PCT/EP2020/080893
(87) Internationale Veröffentlichungsnummer: WO 2021/094153

(56) Entgegenhaltungen:
- EP-A1- 2 058 089
- DE-A1- 102013 201 708

## Beschreibung

Die vorliegende Erfindung betrifft ein Verfahren zum Steuern und Regeln einer Werkzeugmaschine, insbesondere Meißelhammer, mit einem Antrieb, einer Steuerungseinrichtung, einer Sensoreinrichtung, einer Übertragungseinrichtung und einer Handgriffvorrichtung, wobei die Handgriffvorrichtung ein Hebelelement mit einem Signalgeber enthält, welches relativ zu der Sensoreinrichtung schwenkbar ist.

Ein Meißelhammer gemäß dem Stand der Technik wird zum Bearbeiten (d.h. Aufreißen, Abbrechen oder Meißeln) von mineralischen Werkstoffen, wie beispielsweise Beton, Ziegel oder dergleichen verwendet. Der Meißelhammer kann auch als Abbruch-, Abbau- oder Aufbrechhammer bezeichnet werden. Der Meißelhammer verfügt über einen Antrieb, der mit Hilfe eines Übertragungsmechanismus Schläge auf ein Meißelwerkzeug (auch Meißel genannt) überträgt. Bei dem Antrieb kann es sich um einen Elektromotor oder Verbrennungsmotor handeln.

Für gewöhnlich weist der Meißelhammer zwei Handgriffe auf, welche an gegenüberliegenden Seiten des Gehäuses des Meißelhammers positioniert sind. Wenigstens einer der beiden Handgriffe umfasst einen Aktivierungsschalter, mit dem der Meißelhammer aktiviert bzw. eingeschaltet werden kann. Die Handgriffe erstrecken sich dabei meistens in einem stumpfen Winkel zu einer Längsachse des Gehäuses des Meißelhammers. Zur Verwendung des Meißelhammers wird der Aktivierungsschalter gedrückt und der Meißelhammer wird aktiviert, sodass Schläge von dem Antrieb auf den Meißel übertragen werden.

Ein derartiger Meißelhammer ist beispielsweise aus der EP 2 058 089 A1 bekannt, die ein Verfahren nach dem Oberbegriff des Anspruchs 1 offenbart.

Ein Problem bei einem Meißelhammer gemäß dem Stand der Technik besteht darin, dass nach der Aktivierung (d.h. Einschalten) des Meißelhammers für gewöhnlich der Antrieb mit einer maximalen Drehzahl und folglich der Meißelhammer mit voller Leistung betrieben wird. Wenn ein Anwender den Meißelhammer zu diesem Zeitpunkt noch nicht in einem ausreichenden Masse kontrolliert, d.h. der Anwender noch nicht beide Hände an den jeweiligen Handgriffen positioniert hat und den Meißelhammer festhält, ist der Meißelhammer unzureichend geführt und ein adäquates sowie sicheres Arbeiten ist nicht möglich.

Es ist somit Aufgabe der vorliegenden Erfindung das vorstehend erwähnte Problem zu lösen und ein Verfahren zum Steuern und Regeln einer Werkzeugmaschine, insbesondere Meißelhammer, bereitzustellen, welche ein einfaches sowie sicheres Arbeiten mit einer Werkzeugmaschine, insbesondere mit einem Meißelhammer, ermöglicht.

Die Aufgabe wird gelöst durch den Gegenstand in Anspruch 1.

Vorteilhafte Ausführungsformen sind in den Unteransprüchen aufgeführt.

Die Aufgabe wird gelöst durch ein Verfahren zum Steuern und Regeln einer Werkzeugmaschine, insbesondere Meißelhammer, mit einem Antrieb, einer Steuerungseinrichtung, einer Sensoreinrichtung, einer Übertragungseinrichtung und einer Handgriffvorrichtung, wobei die Handgriffvorrichtung ein Hebelelement mit einem Signalgeber enthält, welches relativ zu der Sensoreinrichtung schwenkbar ist.

Erfindungsgemäß sind die Verfahrensschritte enthalten:
- Erfassen einer ersten und zweiten Position des Signalgebers durch die Sensoreinrichtung;
- Ermitteln einer Beschleunigung des Signalgebers von der ersten Position zu der zweiten Position durch die Steuerungseinrichtung; und
- Einstellen von einem Aktivierungsmodus in einen Deaktivierungsmodus für den Antrieb durch die Steuerungseinrichtung, wenn die ermittelte Beschleunigung des Signalgebers einen vorbestimmten Schwellwert erreicht.

Entsprechend einer vorteilhaften Ausgestaltung der vorliegenden Erfindung kann es möglich sein, dass die zweite Position des Signalgebers in einer Richtung oberhalb der ersten Position des Signalgebers angeordnet ist, sodass die Beschleunigung des Signalgebers in die Richtung ermittelbar ist. Hierdurch ist sichergestellt, dass eine Bewegung und eine Beschleunigung der Handgriffvorrichtung nach unten, d.h. in Richtung des Werkzeugs erfasst bzw. ermittelt wird.

Gemäß einer vorteilhaften Ausgestaltung der vorliegenden Erfindung kann es möglich sein, dass das Einstellen des Deaktivierungsmodus für den Antrieb durch ein aktives Abbremsen des Antriebs durch eine Bremsvorrichtung durchgeführt wird. Hierdurch kann ein möglichst schnelles Anhalten des Antriebs ermöglicht werden.

Weitere Vorteile ergeben sich aus der folgenden Figurenbeschreibung. In den Figuren sind verschiedene Ausführungsbeispiele dargestellt, die das Verständnis des erfindungsgemäßen Verfahren erleichtern.

In den Figuren sind gleiche und gleichartige Komponenten mit gleichen Bezugszeichen beziffert.

Es zeigen:
- Figur 1: eine schematische Vorderansicht auf eine Werkzeugmaschine in Form eines Meißelhammers mit einer Handgriffvorrichtung
- Figur 2a: eine Detailansicht auf die Handgriffvorrichtung in einer ersten Positionierung gemäß einem ersten Ausführungsbeispiel;
- Figur 2b: eine Detailansicht auf die Handgriffvorrichtung in einer zweiten Positionierung gemäß dem ersten Ausführungsbeispiel;
- Figur 2c: eine Detailansicht auf die Handgriffvorrichtung in einer dritten Positionierung gemäß dem ersten Ausführungsbeispiel;
- Figur 3a: eine Detailansicht auf die Handgriffvorrichtung in einer ersten Positionierung gemäß einem zweiten Ausführungsbeispiel;
- Figur 3b: eine Detailansicht auf die Handgriffvorrichtung in einer zweiten Positionierung gemäß dem zweiten Ausführungsbeispiel;
- Figur 3c: eine Detailansicht auf die Handgriffvorrichtung in einer dritten Positionierung gemäß dem zweiten Ausführungsbeispiel;
- Figur 4a: eine Detailansicht auf die Handgriffvorrichtung in einer ersten Positionierung gemäß einem dritten Ausführungsbeispiel;
- Figur 4b: eine Detailansicht auf die Handgriffvorrichtung in einer zweiten Positionierung gemäß dem dritten Ausführungsbeispiel; und
- Figur 4c: eine Detailansicht auf die Handgriffvorrichtung in einer dritten Positionierung gemäß dem dritten Ausführungsbeispiel.

### Ausführungsbeispiele:

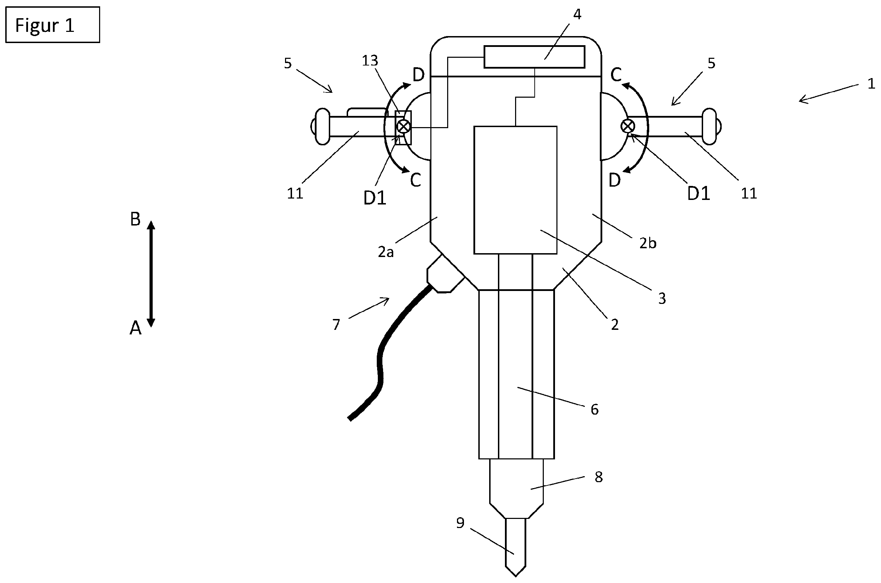

Figur 1 zeigt eine Werkzeugmaschine 1 in Form eines Meißelhammers. Die Werkzeugmaschine 1 kann jedoch auch in Form eines Bohrhammers, einer Bohrmaschine, einer Säge, eines Schleifgeräts oder dergleichen ausgestaltet sein.

Wie in Figur 1 angedeutet, enthält die als Meißelhammer ausgestaltete Werkzeugmaschine 1 im Wesentlichen ein Gehäuse 2, einen Antrieb 3, eine Steuerungseinrichtung 4, eine erste und zweite Handgriffvorrichtung 5, eine Übertragungseinrichtung 6, eine Energieversorgungseinrichtung 7 sowie eine Werkzeugaufnahme 8.

Im Inneren des Gehäuses ist im Wesentlichen der Antrieb 3, die Steuerungseinrichtung 4 und die Übertragungseinrichtung 6 positioniert. Der Antrieb 3 ist dabei als Elektromotor ausgestaltet. Bei dem Elektromotor kann es sich um einen bürstenlosen Elektromotor handeln.

An einem unteren Ende des Gehäuses 2 der Werkzeugmaschine 1 ist die Werkzeugaufnahme 8 positioniert. Mit Hilfe der Werkzeugaufnahme 8 kann ein Werkzeug 9 aufgenommen und gehalten werden. In den Figuren ist das Werkzeug 9 als Meißel ausgestaltet.

Darüber hinaus ist an der ersten Seitenwand 2a des Gehäuses 2 der Werkzeugmaschine 1 die Energieversorgungseinrichtung 7 vorgesehen. In dem angeführten Beispiel der Werkzeugmaschine 1 handelt sich bei der Energieversorgungseinrichtung 7 um ein Stromnetzanschluss sowie um ein Stromnetzkabel. Ein freies Ende des Stromnetzkabels kann mit einem Stromnetzanschluss (auch Steckdose genannt) verbunden werden. Mit Hilfe der Energieversorgungseinrichtung 7 kann die Werkzeugmaschine 1 und insbesondere der als Elektromotor ausgestaltete Antrieb 3 mit Energie, beispielsweise mit elektrischer Energie, versorgt werden.

Entsprechend einer alternativen Ausgestaltungsform der Werkzeugmaschine 1 kann die Energieversorgungseinrichtung 7 auch als ein einziger Akkumulator oder als mehrere Akkumulatoren ausgestaltet sein: Mit Hilfe einer oder mehreren Akku-Schnittstellen ist der einzelne oder mehrere Akkumulatoren an oder in dem Gehäuse 2 der Werkzeugmaschine 1 positioniert.

Wie bereits vorstehend erwähnt ist der Antrieb 3 in der vorliegenden Ausgestaltungsform der Werkzeugmaschine 1 als Elektromotor ausgestaltet. Alternativ kann es sich bei dem Antrieb 3 auch um einen Verbrennungsmotor handeln. In diesem Falle ist die Energieversorgungseinrichtung 7 als Treibstofftank ausgestaltet.

Gemäß einer weiteren alternativen Ausgestaltungsform der Werkzeugmaschine 1 kann der Antrieb 3 auch in Form eines pneumatischen Antriebs bzw. Kompressors ausgestaltet sein. Bei der Energieversorgungseinrichtung 7 kann es sich in diesem Fall um einen Druckluftanschluss oder Druckluftvorrat an oder in der Werkzeugmaschine 1 handeln.

Der als Elektromotor ausgestaltete Antrieb 3 dient zum Erzeugen eines Drehmoments. Mit Hilfe der Übertragungseinrichtung 6 kann das vom Antrieb 3 erzeugte Drehmoment in Form von (Hammer-)Schlägen auf die Werkzeugaufnahme 8 und schließlich auf das als Meißel ausgestaltete Werkzeug 9 übertragen werden. Die Übertragungseinrichtung 6 kann auch als Schlagwerk bezeichnet werden. Je höher die Frequenz der Schläge, desto mehr Schlagenergie wird erzeugt.

Die Steuerungseinrichtung 4 ist mit der ersten und zweiten Handgriffvorrichtung 5 sowie mit dem Antrieb 3 verbunden. Signale und Kommunikationsdaten können somit zwischen den Handgriffvorrichtungen 5, dem Antrieb 3 und der Steuerungseinrichtung 4 gesendet und empfangen werden. Die Steuerungseinrichtung 4 dient zum Steuern und Regeln der unterschiedlichen Funktionen der Werkzeugmaschine 1 sowie insbesondere zum Einstellen der Parameter bzw. Betriebsparameter des Antriebs 3. Mit Hilfe der Steuerungseinrichtung 4 kann damit speziell die Drehzahl des als Elektromotors ausgestalten Antriebs 3 als Parameter bzw. Betriebsparameter eingestellt werden.

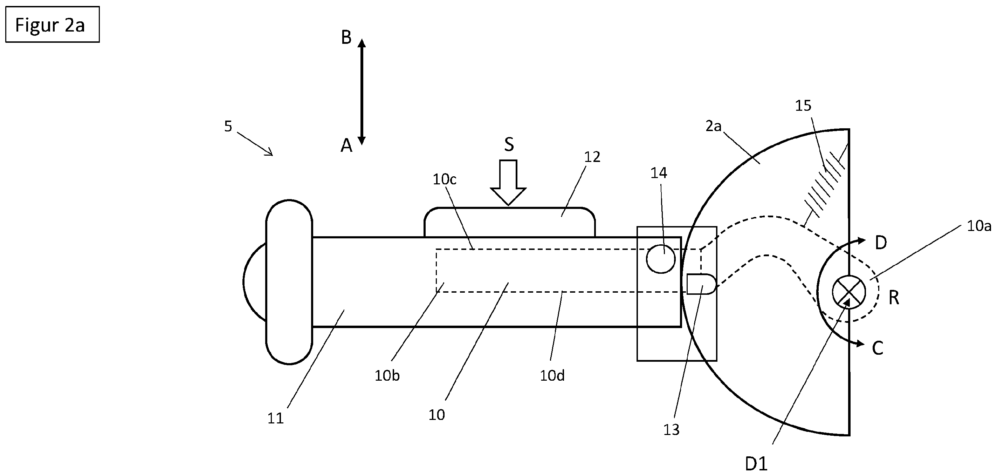

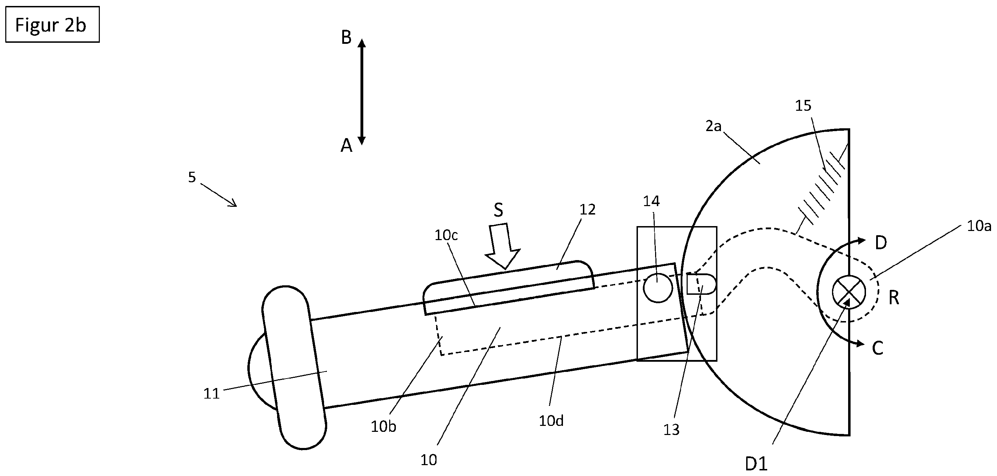

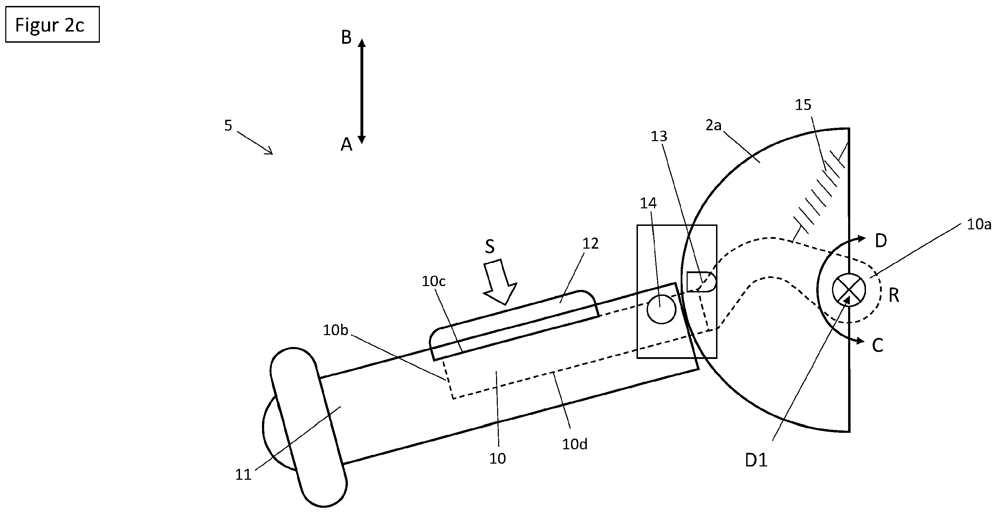

Die erste Handgriffvorrichtung 5 ist bewegbar an einer ersten Seitenwand 2a des Gehäuses 2 und die zweite Handgriffvorrichtung 5 ist bewegbar an einer zweiten Seitenwand 2b des Gehäuses 2 positioniert. Wie in Figur 1 und 2 gezeigt enthält sowohl die erste als auch die zweite Handgriffvorrichtung 5 jeweils ein Hebelelement 10 und ein Griffstück 11. Das jeweilige Hebelelement 10 der ersten und zweiten Handgriffvorrichtung 5 ist entsprechend über einen entsprechenden ersten Drehpunkt D1 in Drehrichtung C oder D schwenkbar gelagert. Die erste und zweite Handgriffvorrichtung 5 dient zum Halten und Führen der Werkzeugmaschine 1 durch einen Anwender. Der Anwender ist in den Figuren nicht gezeigt.

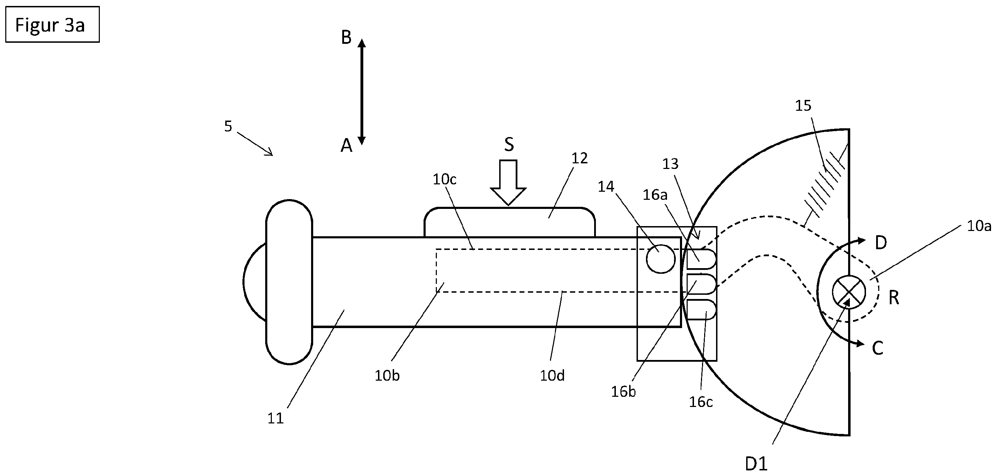

In den Figuren 3a bis 3c ist die Handgriffvorrichtung 5 in Form eines ersten Ausführungsbeispiels dargestellt. Die Handgriffvorrichtung 5 gemäß dem ersten Ausführungsbeispiel enthält dabei im Wesentlichen ein Hebelelement 10, ein Griffstück 11, ein Aktivierungselement 12, eine Sensoreinrichtung 13 sowie einen Signalgeber 14.

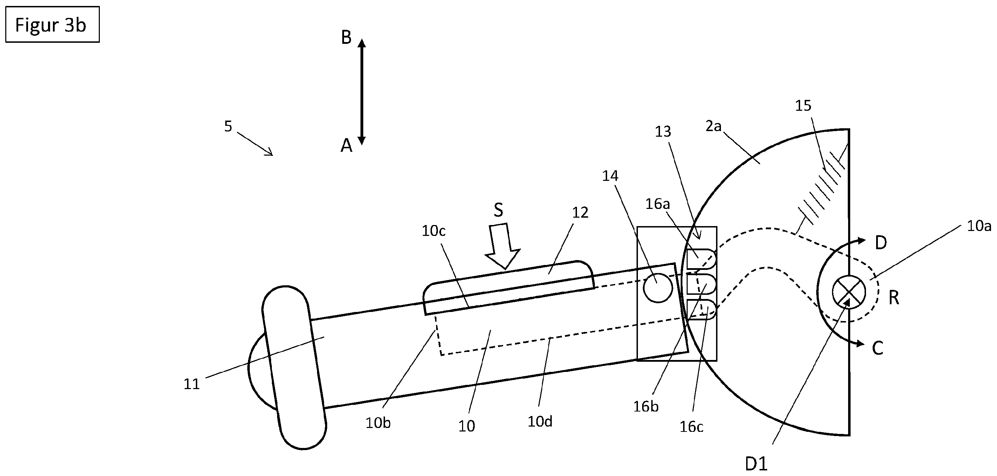

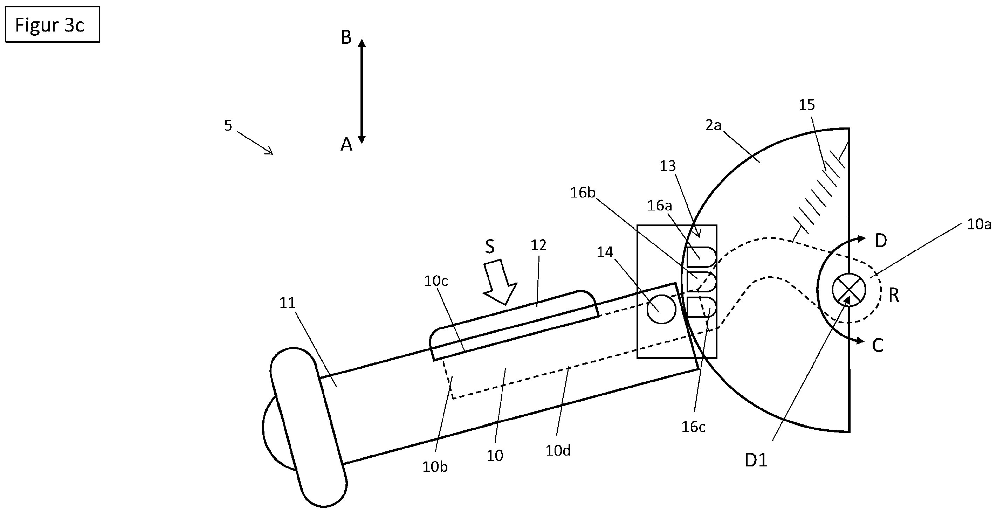

Das als Betätigungsschalter ausgestaltete Aktivierungselement 12 dient zum Aktivieren des Antriebs 3 der Werkzeugmaschine 1. Das Aktivierungselement 12 kann durch Ausüben einer Kraft in Richtung S reversibel von einer ersten Position in eine zweite Position gebracht wird. In Figur 3a ist das Aktivierungselement 12 in der ersten Position, d.h. in einem nicht gedrückten Zustand, gezeigt. Die erste Position entspricht dabei der obersten Position. Die Aktivierung des Antriebs 3 erfolgt sobald das Aktivierungselement 12 von der ersten Position in die zweite Position wegbewegt wird. In Figur 3b und 3c ist das Aktivierungselement 12 jeweils in der zweiten Position, d.h. in einem gedrückten Zustand, dargestellt. Das Aktivierungselement 12 ist so mit der Steuerungseinrichtung 4 verbunden, dass Signale zwischen dem Aktivierungselement 12 und der Steuerungseinrichtung 4 ausgetauscht werden können. Die Verbindung zwischen dem Aktivierungselement 12 und der Steuerungseinrichtung 4 ist in den Figuren nicht dargestellt. Die jeweilige Position, d.h. die erste oder zweite Position, des Aktivierungselements 12 wird an die Steuerungseinrichtung 4 mit Hilfe eines entsprechenden Signals übermittelt. Wenn das Aktivierungselement 12 sich in der zweiten Position befindet, ist lediglich der Antrieb 3 der Werkzeugmaschine 1 aktiviert. Die als Schlagwerkeinrichtung ausgestaltete Übertragungseinrichtung 6 wird nicht nur durch das Drücken des Aktivierungselements 12 in Pfeilrichtung S aktiviert bzw. gestartet.

Die Sensoreinrichtung 13 ist so mit der Steuerungseinrichtung 4, dass Signale, Daten und Informationen zwischen der Sensoreinrichtung 13 und der Steuerungseinrichtung 4 ausgetauscht werden können.

Das Hebelelement 10 ist im Wesentlichen als länglicher Hebelarm mit einem ersten Ende 10a und zweiten Ende 10b sowie mit einer Ober- und Unterseite 10c, 10d ausgestaltet. Das Hebelelement 10 ist mit dem ersten Ende 10a über einen ersten Drehpunkt D1 in eine Drehrichtung C oder D reversibel schwenkbar zu dem Gehäuse 2 der Werkzeugmaschine 1 montiert. Wenn eine Kraft in Richtung A auf die Oberseite 10c des Hebelelements 10 ausgeübt wird, schwenkt das Hebelelement 10 um den Drehpunkt D1 in Drehrichtung C. Wenn keine Kraft mehr auf die Oberseite 10c des Hebelelements 10 ausgeübt wird, schwenkt das Hebelelement 10 um den ersten Drehpunkt D1 mit Hilfe eines ersten Federelements 15 in Drehrichtung D in die Ausgangsposition zurück. Das erste Federelement 15 kann dabei in Form einer Spiralfeder oder Drehstabfeder ausgestaltet sein.

Der Signalgeber 14 ist fest mit dem Hebelelement 10 verbunden und in Form eines Magneten ausgestaltet. Bei dem Magneten kann es sich um einen Permanentmagnet handeln. Wie in den Figuren 3a bis 3c gezeigt ist der als Magnet ausgestaltete Signalgeber 14 am dem Hebelelement 10 positioniert. Durch die Positionierung an dem Hebelelement 10 kann der Signalgeber 14 relativ zu dem Gehäuse 2 der Werkzeugmaschine 1 bewegt werden.

Die Sensoreinrichtung 13 ist an der ersten Seitenwand 2a des Gehäuses 2 der Werkzeugmaschine 1 positioniert und enthält im Wesentlichen einen ersten, zweiten und dritten Hall-Sensor 16a, 16b, 16c. Wie in den Figuren 3a bis 3c gezeigt, sind die drei Hall-Sensoren 16a, 16b, 16c untereinander in Richtung A an dem Gehäuse 2 der Werkzeugmaschine 1 positioniert. Die Hall-Sensoren 16a, 16b, 16c sind so an dem Gehäuse 2 der Werkzeugmaschine 1 positioniert, dass stets wenigstens einer der drei Hall-Sensoren 16a, 16b, 16c die Position des als Magneten ausgestalteten Signalgebers 14 detektieren kann, wenn das Hebelelement 10 in Drehrichtung C oder D geschwenkt wird.

Gemäß einer alternativen Ausgestaltungsform können auch mehr oder weniger als drei Hall-Sensoren vorgesehen sein.

Wie bereits vorstehend erwähnt, ist in Figur 3a das Aktivierungselement 12 nicht in Richtung A gedrückt und die Handgriffvorrichtung 5 ist nicht durch Ausüben einer Kraft in Richtung C geschwenkt. Der erste (d.h. oberste) Hall-Sensor 16a der Sensoreinrichtung 13 erfasst die Nähe des als Magneten ausgestalteten Signalgebers 14. Die Sensoreinrichtung 13 sendet ein entsprechendes Signal an die Steuerungseinrichtung 4, um der Steuerungseinrichtung 4 mitzuteilen, dass keine Kraft auf die Handgriffvorrichtung 5 ausgeübt wird. In diesem Zustand ist weder der Antrieb 3 noch die Übertragungseinrichtung 6 aktiviert. Folglich wird keine Schlagenergie auf das Werkzeug 9 übertragen. Beispielsweise könnte ein Werkzeugwechsel in diesem Zustand sicher vorgenommen werden.

In Figur 3b wird eine erste Kraft in Richtung A auf das Aktivierungselement 12 und die Handgriffvorrichtung 5 ausgeübt. Hierdurch wird das Aktivierungselement 12 von der ersten Position in die zweite Position gebracht. Der Antrieb 3 wird daraufhin aktiviert. Gleichzeitig wird durch das Ausüben der Kraft in Richtung A die Handgriffvorrichtung 5 und damit das Hebelelement 10 um den ersten Drehpunkt D1 in Drehrichtung C geschwenkt. In Figur 3b wird so viel Kraft auf die Handgriffvorrichtung 5 und das Hebelelement 10 ausgeübt, dass sich Handgriffvorrichtung 5 in einer mittleren Position befindet. Der als Magnet ausgestaltete Signalgeber 14 ist dabei so positioniert, dass der zweite (mittlere) Hall-Sensor 16b der Sensoreinrichtung 13 den Magneten erfassen kann. Die Sensoreinrichtung 13 erfasst somit, dass sich die Handgriffvorrichtung 5 in einer mittleren Position befindet. Wenn die Sensoreinrichtung 13 mit Hilfe des zweiten Hall-Sensors 16b die mittlere Position der Handgriffvorrichtung 5 erfasst, wird ein entsprechendes Signal an die Steuerungseinrichtung 4 gesendet. Durch das Signal wird der Steuerungseinrichtung 4 mitgeteilt, dass eine mittlere Kraft von dem Anwender auf die Handgriffvorrichtung 5 ausgeübt wird. Die Steuerungseinrichtung 4 steuert den als Elektromotor ausgestalten Antrieb 3 so an, dass in Abhängigkeit der mittleren Kraftausübung auf die Handgriffvorrichtung 5 eine erste Drehzahl für den Antrieb 3 eingestellt wird. Durch die erste Drehzahl wird ein erster Wert an Schlagenergie von der Übertragungseinrichtung 6 auf das Werkzeug 9 gegeben.

In Figur 3c wird eine zweite Kraft in Richtung A auf die Handgriffvorrichtung 5 ausgeübt. Die zweite Kraft ist dabei größer als die erste Kraft. Wie in Figur 3c ersichtlich befindet sich das Aktivierungselement 12 weiterhin in der zweiten (d.h. gedrückten) Position. Der Antrieb 3 ist durch das Drücken des Aktivierungselements 12 in Richtung S weiterhin aktiviert. Durch das Ausüben der zweiten (d.h. erhöhten) Kraft in Richtung A auf die Handgriffvorrichtung 5 wird das Hebelelement 10 weiter als in Figur 3b in Drehrichtung C geschwenkt. Das Hebelelement 10 wird dabei soweit geschwenkt, dass sich der an dem Hebelelement 10 positionierte Signalgeber 14 auf Höhe des dritten (d.h. tiefsten) Hall-Sensors 16c befindet. Die Sensoreinrichtung 13 erfasst somit, dass maximaler Druck auf die Handgriffvorrichtung 5 ausgeübt wird und sich die Handgriffvorrichtung 5 in einer unteren (d.h. tiefsten) Position befindet. Wenn die Sensoreinrichtung 13 mit Hilfe des dritten Hall-Sensors 16c die unterste Position der Handgriffvorrichtung 5 erfasst, wird ein entsprechendes Signal an die Steuerungseinrichtung 4 gesendet. Durch das Signal wird der Steuerungseinrichtung 4 mitgeteilt, dass eine maximale Kraft von dem Anwender auf die Handgriffvorrichtung 5 ausgeübt wird. Die Steuerungseinrichtung 4 steuert den als Elektromotor ausgestalten Antrieb 3 so an, dass in Abhängigkeit der maximalen Kraftausübung auf die Handgriffvorrichtung 5 eine zweite Drehzahl für den Antrieb 3 eingestellt wird. Der zweite Drehzahlwert ist dabei höher als der erste Drehzahlwert. Durch die zweite Drehzahl wird ein zweiter Wert an Schlagenergie von der Übertragungseinrichtung 6 auf das Werkzeug 9 gegeben. der zweite Wert an Schlagenergie ist höher als der erste Wert an Schlagenergie.

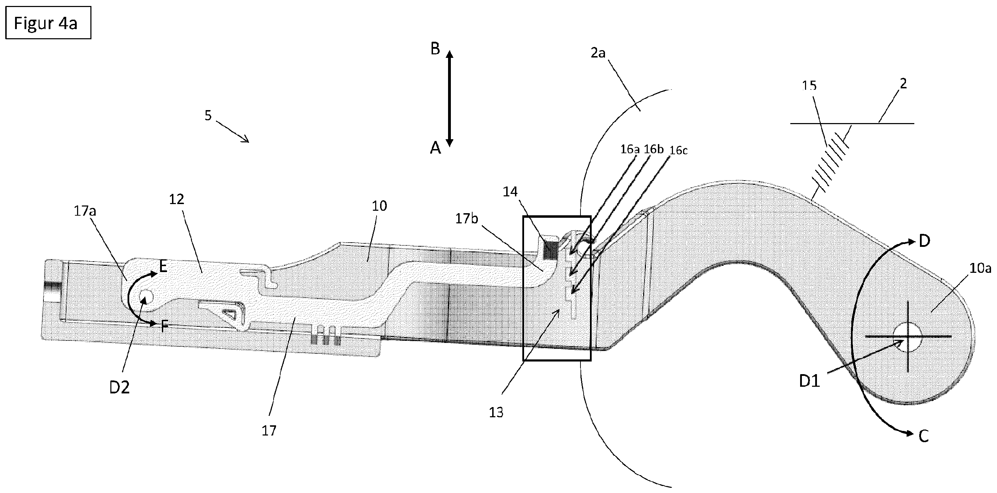

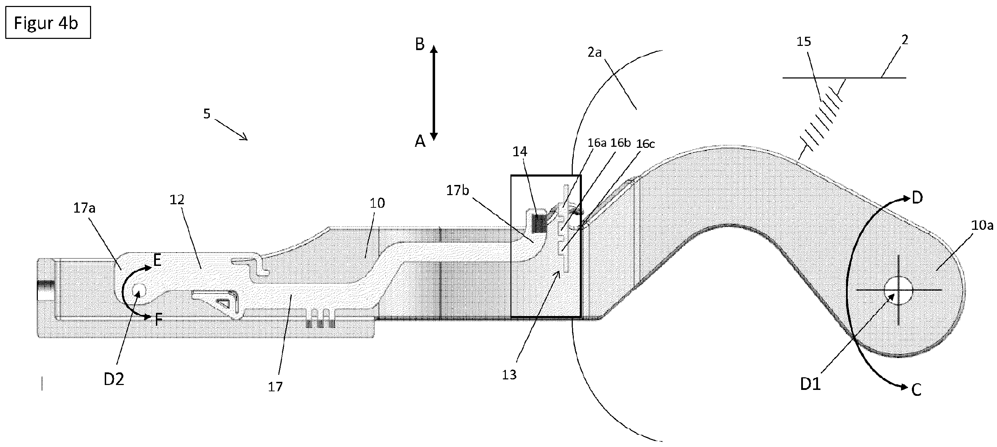

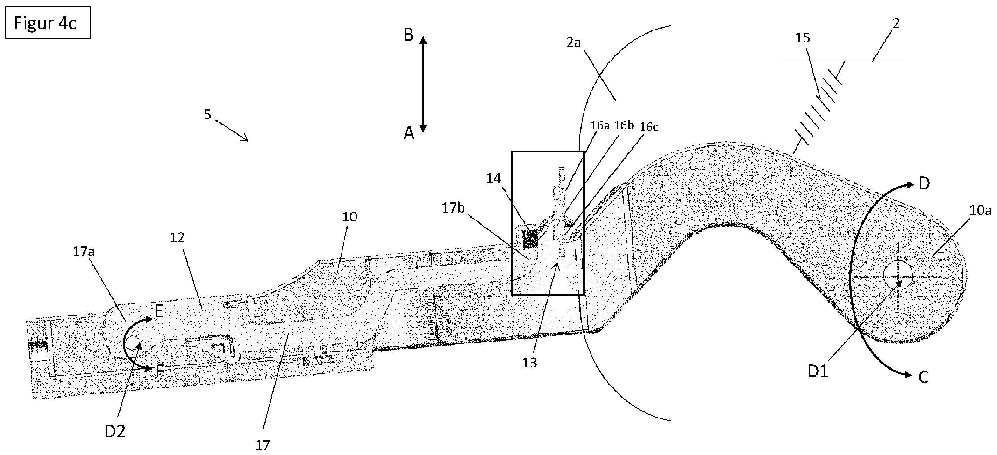

In den Figuren 4a bis 4c ist die Handgriffvorrichtung 5 in Form eines zweiten Ausführungsbeispiels dargestellt. Die Handgriffvorrichtung 5 gemäß dem zweiten Ausführungsbeispiel enthält dabei im Wesentlichen ein Hebelelement 10, ein Griffstück 11, ein Aktivierungselement 12, eine Sensoreinrichtung 13 sowie einen Signalgeber 14.

Wie in den Figuren 4a bis 4c erkennbar, ist im Gegensatz zu der Handgriffvorrichtung 5 gemäß dem ersten Ausführungsbeispiel bei dem zweiten Ausführungsbeispiel ist das Aktivierungselement 12 und der Signalgeber 14 an einem Verbindungselement 17 positioniert. Das Verbindungselement 17 ist im Wesentlichen in länglicher Form ausgestaltet und weist ein erstes und zweites Ende 17a, 17b auf. Das Aktivierungselement 12 ist an dem ersten Ende 17a und der Signalgeber 14 ist an dem zweiten Ende 17b des Verbindungselements 17 positioniert.

Zusätzlich ist an dem ersten Ende 17a des Verbindungselements 17 ein Drehlager vorgesehen, sodass das Verbindungselement 17 um einen zweiten Drehpunkt D2 in Drehrichtung E oder F geschwenkt werden kann. Durch Ausüben einer Kraft in Richtung A auf das Aktivierungselement 12 wird das Verbindungselement 17 um den Drehpunkt D2 in Drehrichtung E geschwenkt bzw. gedreht.

Wenn das Verbindungselement 17 um den Drehpunkt D2 in Drehrichtung E geschwenkt, bewegt sich der an dem zweiten Ende positionierte Signalgeber 14 in Richtung A. Der als Magnet ausgestaltete Signalgeber 14 wird damit an den drei Hall-Sensoren 16a, 16b, 16c der Sensoreinrichtung 13 vorbeigeführt.

Wie bereist vorstehend erwähnt erfasst die Sensoreinrichtung 13 die Positionierung des als Magnet ausgestalteten Signalgebers 14. Über die Positionierung des Signalgebers 14 relativ zu der Sensoreinrichtung 13 kann der Winkel der Handgriffvorrichtung 5 und die Kraft ermittelt werden, mit der die Handgriffvorrichtung 5 in Richtung A gedrückt wird. Wie ebenfalls bereist vorstehend erwähnt wird die Drehzahl des Antriebs 3 und damit die Abgabe der Schlagenergie von der Übertragungseinrichtung 6 auf das Werkzeug 9 in Abhängigkeit der Position des Signalgebers 14 bzw. der Position des Hebelelements 10 zu der Sensoreinrichtung 13 bzw. zu dem Gehäuse 2 der Werkzeugmaschine 1 eingestellt.

Wenn keine Kraft bzw. kein Druck mehr in Richtung A auf das Aktivierungselement 12 mehr ausgeübt wird, bewegt sich mit Hilfe eines zweiten Federelements das Aktivierungselement 12 in Richtung B wieder in die Ausgangsposition. Das Verbindungselement 17 wird mit Hilfe des zweiten Federelements um den Drehpunkt D2 wieder in Drehrichtung F geschwenkt. Das zweite Federelement ist in den Figuren nicht gezeigt.

In den Figuren 2a bis 2c ist die Handgriffvorrichtung 5 in Form eines dritten Ausführungsbeispiels dargestellt. Die Handgriffvorrichtung 5 gemäß dem dritten Ausführungsbeispiel enthält dabei im Wesentlichen ein Hebelelement 10, ein Griffstück 11, ein Aktivierungselement 12, eine Sensoreinrichtung 13 sowie einen Signalgeber 14.

Die Ausgestaltung der Handgriffvorrichtung 5 gemäß dem dritten Ausführungsbeispiel ähnelt dabei der Handgriffvorrichtung 5 gemäß dem ersten Ausführungsbeispiel. Die Handgriffvorrichtung 5 gemäß dem dritten Ausführungsbeispiel unterscheidet sich von der Handgriffvorrichtung 5 gemäß dem ersten Ausführungsbeispiel dahingehend, dass die Sensoreinrichtung 13 anstelle eines ersten, zweiten und dritten Hall-Sensors 16a, 16b, 16c leidglich einen 3D-Sensor enthält. Alternativ kann die Sensoreinrichtung auch mehr als einen 3D-Sensor enthalten.

Der 3D-Sensor kann auch als TOF-Kamera (= Time Of Flight Kameras) und/oder PMD-Sensoren (= Photomischdetektoren) bezeichnet werden.

Damit die Steuerungseinrichtung 4 den Antrieb 3 von einem Deaktivierungsmodus in einen Aktivierungsmodus einstellt muss eine ausreichend große bzw. hohe Beschleunigung des Hebelelements 10 mit dem Signalgeber 14 durch die Sensoreinrichtung 13 erfasst und ermittelt werden. Hierzu wird zunächst eine erste und zweite Position des Signalgebers 14 durch die Sensoreinrichtung 13 erfasst. Die Ausgestaltung der Sensoreinrichtung 13 erfasst die Positionen des als Magneten ausgestalteten Signalgebers 14. Die Sensoreinrichtung 13 sendet in Form von Signalen die Daten der beiden Positionen des Signalgebers 14 relativ zu der Sensoreinrichtung 13 an die Steuerungseinrichtung 4. Die Steuerungseinrichtung 4 ermittelt anhand der zwei Positionen sowie der Zeitdauer zwischen den beiden Positionen eine Beschleunigung des Signalgebers 14. Wenn die ermittelte Beschleunigung wenigsten einen vorbestimmten Schwellwert erreicht, wird mit Hilfe der Steuerungseinrichtung 4 der Antrieb 3 von einem Deaktivierungsmodus in einen Aktivierungsmodus eingestellt.

Die vorbestimmten Schwellwerte für die ermittelte Beschleunigung sind mit Hilfe einer Look-Up-Tabelle in der Steuerungseinrichtung 4 gespeichert.

### Bezugszeichenliste

- 1: Werkzeugmaschine
- 2: Gehäuse
- 2a: erste Seite des Gehäuses
- 2b: zweite Seite des Gehäuses
- 3: Antrieb
- 4: Steuerungseinrichtung
- 5: Handgriffvorrichtung
- 6: Übertragungseinrichtung
- 7: Energieversorgungseinrichtung
- 8: Werkzeugaufnahme
- 9: Werkzeug
- 10: Hebelelement
- 10a: erstes Ende des Hebelelements
- 10b: zweites Ende des Hebelelements
- 10c: Oberseite des Hebelelements
- 10d: Unterseite des Hebelelements
- 11: Griffstück
- 12: Aktivierungselement
- 13: Sensoreinrichtung
- 14: Signalgeber
- 15: erstes Federelement
- 16a: erster Hall-Sensor
- 16b: zweiter Hall-Sensor
- 16c: dritter Hall-Sensor
- 17: Verbindungselement
- 17a: erstes Ende des Verbindungselements
- 17b: zweites Ende des Verbindungselements

## Patentansprüche

1. Verfahren zum Steuern und Regeln einer Werkzeugmaschine (1), insbesondere Meißelhammer, mit einem Antrieb (3), einer Steuerungseinrichtung (4), einer Sensoreinrichtung (13), einer Übertragungseinrichtung (6) und einer Handgriffvorrichtung (5), wobei die Handgriffvorrichtung (5) ein Hebelelement (10) mit einem Signalgeber (14) enthält, welches relativ zu der Sensoreinrichtung (13) schwenkbar ist,
mit dem Verfahrensschritt:
- Erfassen einer ersten und zweiten Position des Signalgebers (14) durch die Sensoreinrichtung (13);
**gekennzeichnet durch** die Verfahrensschritte:
- Ermitteln einer Beschleunigung des Signalgebers (14) von der ersten Position zu der zweiten Position durch die Steuerungseinrichtung (4); und
- Einstellen von einem Aktivierungsmodus in einen Deaktivierungsmodus für den Antrieb (3) durch die Steuerungseinrichtung (4), wenn die ermittelte Beschleunigung des Signalgebers (14) einen vorbestimmten Schwellwert erreicht.

2. Verfahren nach Anspruch 1,
**dadurch gekennzeichnet, dass** die zweite Position des Signalgebers (14) in einer Richtung (B) oberhalb der ersten Position des Signalgebers (14) angeordnet ist, sodass die Beschleunigung des Signalgebers (14) in die Richtung (B) ermittelbar ist.

3. Verfahren nach Anspruch 1 oder 2,
**dadurch gekennzeichnet, dass** das Einstellen des Deaktivierungsmodus für den Antrieb (3) durch ein aktives Abbremsen des Antriebs durch eine Bremsvorrichtung durchgeführt wird.

## Claims

1. Method for open- and closed-loop control of a machine tool (1), in particular a chipping hammer, having a drive (3), a control apparatus (4), a sensor apparatus (13), a transmission apparatus (6) and a handle device (5), the handle device (5) containing a lever element (10) which has a signal transmitter (14) and is pivotable relative to the sensor apparatus (13), comprising the method step of:
- detecting a first and second position of the signal transmitter (14) by means of the sensor apparatus (13);
**characterized by** the method steps of:
- determining an acceleration of the signal transmitter (14) from the first position to the second position by means of the control apparatus (4); and
- setting the drive (3) from an activation mode to a deactivation mode by means of the control apparatus (4) when the determined acceleration of the signal transmitter (14) reaches a specified threshold.

2. Method according to claim 1,
**characterized in that** the second position of the signal transmitter (14) is arranged in a direction (B) above the first position of the signal transmitter (14) so that the acceleration of the signal transmitter (14) in the direction (B) can be determined.

3. Method according to claim 1 or 2,
**characterized in that** the deactivation mode for the drive (3) is set by actively braking the drive by means of a braking device.

## Revendications

1. Procédé pour la commande et la régulation d'une machine-outil (1), en particulier d'un marteau burineur, comportant un entraînement (3), un appareil de commande (4), un appareil formant capteur (13), un appareil de transmission (6) et un dispositif formant poignée (5), dans lequel le dispositif formant poignée (5) contient un élément formant levier (10) comportant un générateur de signaux (14), lequel élément formant levier peut pivoter par rapport à l'appareil formant capteur (13), comportant l'étape de procédé consistant à :
- détecter, par l'appareil formant capteur (13), une première et une seconde position du générateur de signaux (14) ;
**caractérisé par** les étapes de procédé consistant à :
- déterminer, par l'appareil de commande (4), un parcours du générateur de signaux (14) entre la première position et la seconde position ; et
- régler, par l'appareil de commande (4), l'entraînement (3) d'un mode d'activation à un mode de désactivation lorsque le parcours déterminé du générateur de signaux (14) atteint une valeur seuil prédéfinie.

2. Procédé selon la revendication 1,
**caractérisé en ce que** la seconde position du générateur de signaux (14) est située, dans une direction (B), au-dessus de la première position du générateur de signaux (14) de sorte que le parcours du générateur de signaux (14) dans la direction (B) peut être déterminé.

3. Procédé selon la revendication 1 ou 2,
**caractérisé en ce que** le réglage de l'entraînement (3) en mode de désactivation est réalisé par un freinage actif de l'entraînement à l'aide d'un dispositif de freinage.
